# EUROPEAN PATENT APPLICATION

(11) **EP 1 370 008 A1**
(43) Date of publication of application: **10.12.2003**
(21) Application number: 03252940.6
(22) Date of filing: 12.05.2003
(51) Int. Cl.: H04B 1/44

(54) **Mobile transceiver front-end**

(30) Priority: 07.06.2002 GB 0213147
(71) Applicant: Sony United Kingdom Limited, Weybridge, Surrey KT13 0XW (GB)
(72) Inventor: Glynn, Stuart Francis, Reading, Berkshire RG6 7LT (GB); Clifton, John Christopher, Hook, Hampshire (GB); Kawasaki, Hidetoshi, Weybridge, Surrey KT13 9NF (GB)
(74) Representative: Smith, Samuel Leonard

(57) **Abstract**

A mobile transceiver front end for connecting an antenna to transmit signal components, the front end including a power amplifier for connection to the transmit components, the power amplifier having at least a final stage for feeding the antenna, a transmit isolation switch for selectively isolating the antenna from the transmit components and a receive isolation switch for selectively connecting receive signal components to the antenna and isolating the receive signal components from said final stage wherein the transmit isolation switch is connected in series with and upstream of the final stage of the power amplifier and the receive isolation switch is connected to the signal path between the final stage and an antenna matching network in the signal path.

## Description

The present invention relates to a mobile transceiver front-end and, for such a mobile transceiver front-end, a method of selectively isolating the transmit components of the mobile transceiver from a signal path connecting the power amplifier of the front-end to an antenna.

In mobile transceivers, particularly mobile telephones, also known as cell phones, it is known to provide a single antenna for both transmission and reception of radio frequency signals. For example, where signals are time multiplexed, a switch may be provided in the signal path to the antenna for selectively connecting either the output of a power amplifier to the antenna or the signal received by the antenna to components in the transceiver for demodulating the received signal.

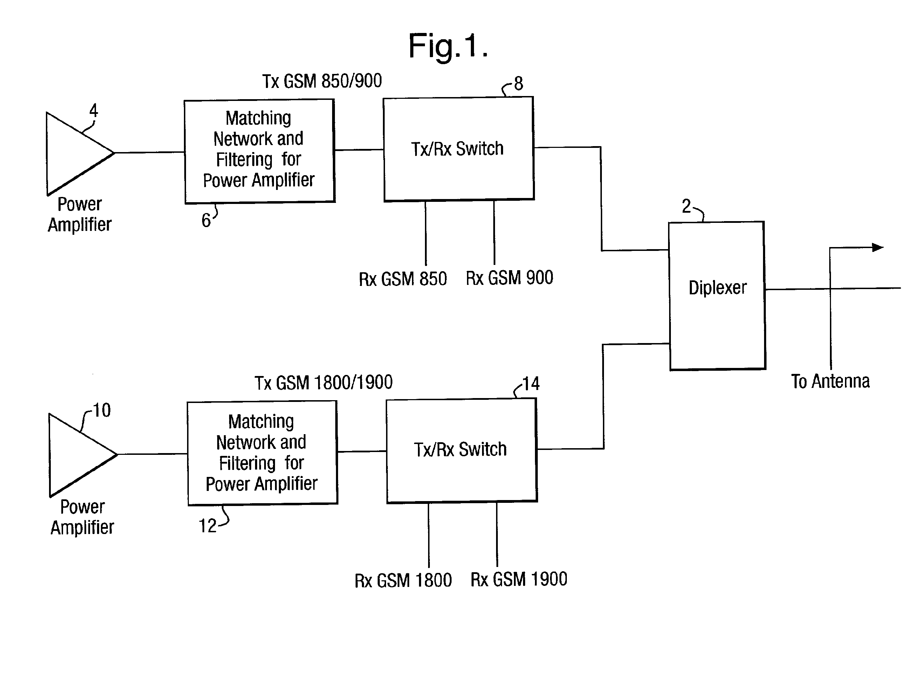

Figure 1 of the accompanying drawings illustrates schematically a known topology for a quad-band front-end, in particular for a GSM telephone.

As illustrated, a diplexer 2 isolates the GSM 850 and GSM 900 bands from the GSM 1800 and GSM 1900 bands. For transmission of GSM 850 and GSM 900 bands, a signal path is provided between a power amplifier 4 and the diplexer 2. The signal path includes a matching network 6 for matching the low impedance output of the power amplifier 4 to the high impedance input of the antenna. This ensures optimum output power and efficiency. The matching network 6 may also include filtering of the signal derived from the power amplifier so as to minimise the emission of unwanted harmonics. The signal path then includes transmit/receive (Tx/Rx) switches 8. During transmission of a signal, the Tx/Rx switches 8 connect the signal from the power amplifier 4 to the antenna, but isolate from the signal path any components for receiving signals. On the other hand, during a receive mode, the Tx/Rx switches 8 prevent the matching components of the power amplifier 4 from loading the receive path and, instead, connect any radio frequency signals received by the antenna to the components for receiving such signals.

For the illustrated quad-band arrangement, a directly equivalent power amplifier 10 matching network 12 and Tx/Rx switches 14 are provided for the GSM 1800/GSM 1900 path.

The present application is based on a recognition that this arrangement gives rise to an undesirable effective efficiency.

The effective efficiency is, in essence, the ratio of the radio frequency power measured at the antenna to the DC power consumed by the power amplifier. In this respect, the present application recognises that the transmit/receive switches used previously to switch between transmission and reception modes introduce undesirable power losses. In particular, it is usual to implement the transmit/receive switches as field effect transistors (FETs), for instance in gallium arsenide (GaAs) technology; or as pin diodes based on silicon. When in the transmit mode with the switches connecting the signal from the power amplifier to the antenna, the switches still have a resistive element which thus introduces power loses.

Power and current consumption of components in mobile transceivers is of great significance, since it directly impacts on talk-time. Therefore, it is important to provide a front-end arrangement for a mobile transceiver with an improved efficiency.

According to the present invention, there is provided a method of selectively isolating the transmit components of a mobile transceiver from a signal path connecting a power amplifier of the mobile transceiver to an antenna, the method including:
connecting a transmit isolation switch in series with and upstream of the final stage of the power amplifier.

According to the present invention there is also provided a mobile transceiver front end for connecting an antenna to transmit signal components, the front end including:
a power amplifier for connection to the transmit components and having at least a final stage for feeding the antenna; and
a transmit isolation switch for selectively isolating the antenna from the transmit components; wherein
the transmit isolation switch is connected in series with and upstream of the final stage of the power amplifier.

By providing the transmit isolation switch upstream of the final stage of the power amplifier, the transmit isolation switch carries a signal having lower power and lower current. Therefore, for given resistive characteristics, the transmit isolation switch will introduce smaller power losses than when located in its known position downstream of the power amplifier.

It is envisaged that the transmit isolation switch will usually be positioned immediately upstream of the final stage, in other words, at the input of the final stage. However, it could be located further upstream at the input of earlier stages of the power amplifier.

Since the transmit isolation switch is located upstream of the final stage of the power amplifier, it is necessarily upstream of any matching network for the antenna. By providing the transmit isolation switch upstream of the matching network, it is functionally positioned adjacent or amongst the components of the power amplifier. It is, therefore, also possible to construct the transmit isolation switch physically with the stages of the power amplifier. This may facilitate production and reduce production costs. It may also reduce the overall size by avoiding the need for connections, such as relatively long tracks, to the transmit isolation switch.

Preferably, the front-end includes a receive isolation switch for selectively connecting receive signal components to the antenna and isolating the receive signal components from the final stage.

The receive isolation switch may operate in a known manner and, indeed, more than one receive isolation switch may be provided for selectively receiving signals of different bands from the antenna in the same way as for known front-ends.

The front end may further include a signal path for connecting the output of the final stage to the antenna and the signal path may include an antenna matching network such that the output impedance of the final stage can be matched to the input impedance of the antenna.

The receive isolation switch is may be connected to the signal path and is for selectively connecting the receive components to the signal path.

Preferably, the receive isolation switch is connected to the signal path between the final stage and the matching network.

In this way, the receive isolation switch is located in the low impedance part of the front end. In its open circuit state, therefore, it is only required to withstand a much smaller voltage. In practical embodiments using FET switches, it is usually necessary to construct each receive isolation switch from four or five series connected FETs. However, by locating the receive isolation switch upstream of the antenna matching network in the low impedance part of the circuit, it is possible to use only one FET.
Hence, there is a significant reduction in the physical space required for the received isolation switches.

With the receive isolation switch connected to the signal path between the final stage and the antenna matching network, the receive isolation switch becomes functionally adjacent the final stage of the power amplifier. Hence, it may also conveniently be located physically adjacent the power amplifier.

In this way, construction of the front end may be facilitated and costs of construction may be reduced. This is particularly the case where the receive isolation switches are constructed as part of the same integrated circuit as the stages of the power amplifier.

It will also be appreciated that, since the receive isolation switches are located physically close to the final stage of the power amplifier, the length of the connections are reduced and there is an overall space saving.

It will be appreciated that the antenna matching network also preferably includes filters for minimising emission of unwanted harmonics.

Preferably, a respective secondary matching network is connected to each receive isolation switch for connecting the receive isolation switch to the receive components such that the impedance presented by the antenna matching network can be matched to the input impedance of the receive components.

It will be noted that, in general, components for receiving and demodulating signals received by the antenna work in a 50 ohm impedance domain. With the receive isolation switches moved to a low-impedance domain, the secondary matching networks allow the modified front end to be used with otherwise conventional receive components.

It may be noted that, even when the receive isolation switches connect to the signal path downstream of the antenna matching network, since, according to the present invention, the transmit isolation switch is necessarily upstream of the antenna matching network, secondary matching networks may be provided to offset the loading effect which the antenna matching network has on the signals passing through the receive isolation switches.

Preferably, the receive isolation switches each comprise a series connected receive isolation FET.

The receive isolation FET may be connected to the signal path via a capacitor for isolating the final stage from the DC bias of the receive isolation FET.

Similarly, preferably, the transmit isolation switch comprises a series connected transmit isolation FET.

Series connected capacitors may be provided either side of the transmit isolation FET to isolate at least the final stage from the DC bias of the isolation FET. The upstream capacitor will provide isolation to any upstream stage or transmit circuitry.

Preferably, the power amplifier and transmit isolation switch are constructed together as an MMIC (Monolithic Microwave Integrated Circuit).

Hence, the stages of the power amplifier and the transmit isolation switch may be constructed together as a single module providing the advantages of construction, cost and size as discussed above.

Indeed, the receive isolation switch may be constructed together with the power amplifier and the transmit isolation switch as an MMIC.

This gives rise to further advantages in performance, size and cost as discussed above. This is particularly so when, as discussed above, the receive isolation switches are connected immediately downstream of the final stage of the power amplifier.

Indeed, the front end described above may be constructed as an MMIC and, according to the present invention, there is provided a front end module including the features discussed above.

According to the present invention, there is also provided a mobile transceiver, such as a mobile telephone, including a front end as described above.

The invention will be more clearly understood from the following description, given by way of example only, with reference to the accompanying drawings, in which:
Fig. 1 illustrates the topology of a known quad-band front-end;
Fig. 2 illustrates a mobile transceiver embodying the present invention;
Fig. 3 illustrates an embodiment of the present invention;
Fig. 4 illustrates more fully the embodiment of Figure 3; and
Fig. 5 illustrates an alternative embodiment of the present invention.

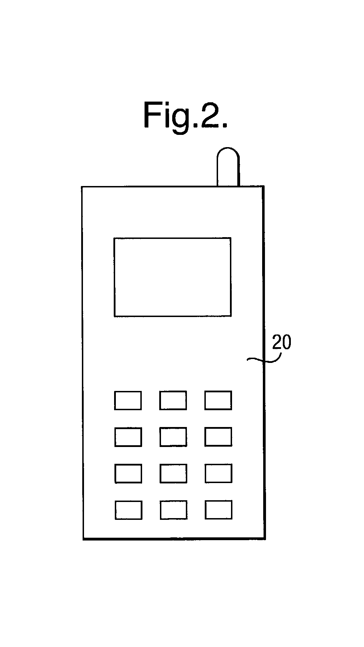

The present invention concerns the construction or topology of the front-end of a mobile transceiver, such as the mobile telephone 20 illustrated in Figure 2. The mobile telephone 20 may conform to GSM, EDGE or UMTS standards and may be single, dual, triple or quad-band.

The front-end of a mobile telephone typically contains radio frequency components for hand set applications, such as a power amplifier, transmit filter, antenna switch, SAW filter and diplexer. It is common to incorporate these components into modules and one module may contain several of the main front-end components. For instance, the antenna switch may be constructed together with the transmit filters or the power amplifier may be constructed together with the transmit filters and the antenna switch.

Providing components together in modules in this way allows the components to be interfaced with the handset mother board without the need for any additional connecting electrical components. Therefore, the modules may be used more easily in the design and assembly of a mobile transceiver.

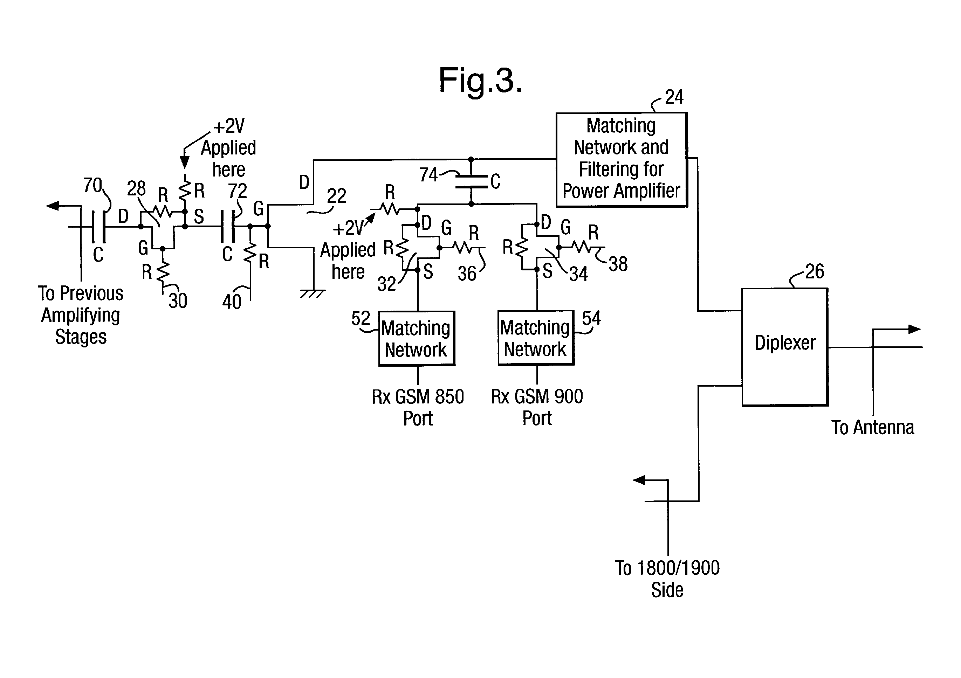

Figure 3 illustrates schematically a preferred embodiment of the present invention. In particular, Figure 3 illustrates the components of a front-end for a mobile transceiver. These components may be provided as discrete components or combined together as one or more modules in a manner to be described below.

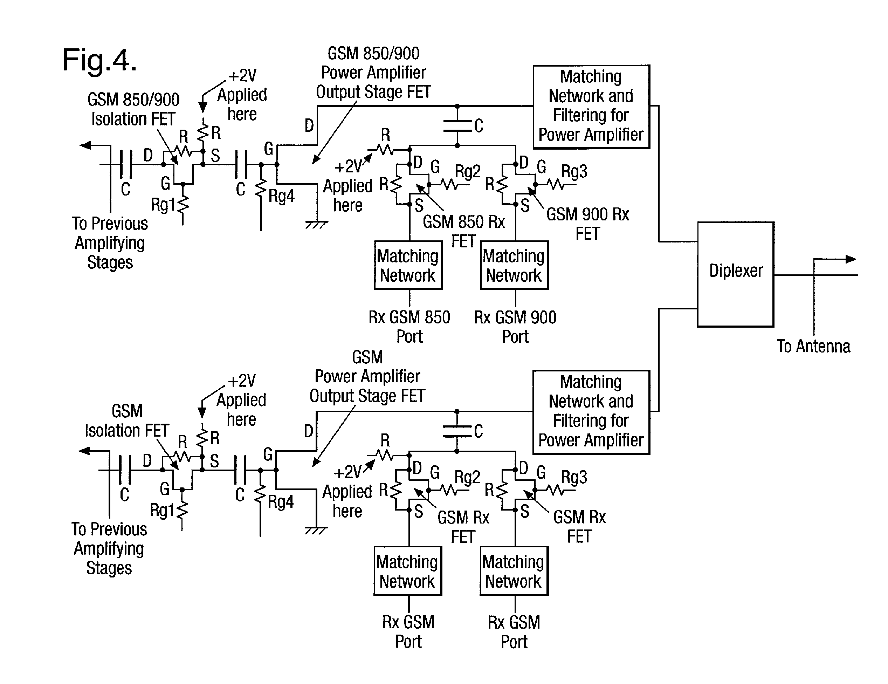

The embodiment of Figure 3 relates to a quad-band transceiver. In particular, it illustrates the signal path for GSM 850 and GSM 900 signals. The signal path for GSM 1800 and GSM 1900 signals is directly equivalent, as illustrated in Figure 4.

It will be appreciated that the present invention is directly applicable to single-band, dual-band and triple-band transceivers.

Mobile transceivers are provided with a power amplifier for amplifying the radio frequency signals provided from various transmit components (not illustrated). The power amplifier is provided to amplify the signals to a high enough level for them to reach a receiver, for example the base station in the case of a cellular telephone.

It will be appreciated that a power amplifier is usually provided with several stages and Figure 3 illustrates the final stage 22 of the power amplifier.

As illustrated, the output or the final stage 22 is provided to a matching network 24. The output of the final stage 22 has an impedance in the region of 2 ohms with a voltage swing of approximately 3 volts or equal to DC supply voltage. The matching network 24 is provided to match the impedance of an antenna to the low impedance presented by the final stage 22. Typically, an antenna might have an impedance of approximately 50 ohms such that on the downstream side of the matching network, the transmit signal may have a voltage swing of approximately 20 volts.

The matching network 24 may also provide filtering of the signal from the power amplifier to minimise the emission of unwanted harmonics.

As illustrated, downstream of the matching network 24, the signal path is connected to a diplexer 26. The diplexer 26 selectively connects to the antenna either the GSM 850/900 arm of the front-end or the GSM 1800/1900 arm of the front end. Clearly, where the front end is intended only for one or both of GSM 850 and GSM 900 or, alternatively, one or both of GSM 1800 and GSM 1900, then there is no need for the diplexer 26.

When it is required to receive a signal, it is necessary to divert the signal from the antenna to receive components (not illustrated) and prevent any matching components of the power amplifier from loading the receive components via the signal path from the power amplifier to the antenna.

As explained above with reference to Figure 1, previously, transmit/receive switches, for instance of a single pole three throw configuration, are located between the matching network and the diplexer. However, according to the present invention, as illustrated in Figure 3, a transmit isolation switch 28 is positioned in the signal path upstream of the final stage 22. In the illustrated embodiment, the transmission switch 28 takes the form of an FET, together with appropriate bias resistors.

By applying an appropriate voltage, for instance +3 volts, to the gate via input 30, the FET of the switch 28 is in conduction, thereby allowing the final stage 22 to amplify and pass on to the matching network 24 a signal provided from upstream transmit components.

On the other hand, when the input 30 to the gate is provided with 0 volts, the FET of the switch 28 is switched off and no signal is provided to the final stage 22.

As illustrated, two receive isolation switches 32 and 34 are also connected to the signal path between the final stage 22 and the matching network 24. The switches selectively connect the signal path to the receive components for receiving a radio frequency signal from the antenna and demodulating it etc. Receive switches are provided for respective bands and, hence, if the front end is only for receiving one band on the transmit/receive signal arm in question, then, consequently, only one receive switch would be required.

In the illustrated embodiment, the receive switches 32 and 34 are constructed from FETs with appropriate biassing resistors.

By providing an appropriate voltage, for instance 3 volts, to the inputs 36 and 38 of the gates of the FET's of the switches 32 and 34, the FET's conduct and, hence, pass on the signal received by an antenna to downstream receive components. On the other hand, by applying a voltage of 0 volts, the FET's are switched off and the receive components are isolated from the signal path between the final stage 22 and matching network 24.

Since the receive isolation switches 32 and 34 are switched off, the receive signal paths feeding any receive components do not load the signal path between the final stage 22 and the matching network 24. Indeed, the effect of the receive isolation switches coupled directly to the drain of the final stage 22 is negligible, since, during transmission, the switches are turned off and put into a high impedance state compared to the low impedance presented by the matching network 24.

In operation, for transmission, the switch 28 is turned on such that the final stage 22 amplifies any signal from transmit components upstream of the power amplifier and the switches 32 and 34 are turned off to prevent the receive components receiving the signal provided by the final stage 22. For receiving a GSM 900 signal, the switch 32 remains off, but the switch 34 turns on so as to connect the appropriate receive components to the signal path. Furthermore, the transmit isolation switch 28 is also turned off. This switch cuts out any loading effect of the previous amplifying stages. Furthermore, the control bias input 40 for the final stage 22 may be provided with a voltage, for instance 0 volts, to switch off the final stage 22. In this way, at this point, the final stage, looks merely like a shunt capacitance. Thus, the GSM 900 receive components can process any signal received from the antenna without any corruption/interference from the power amplifier or upstream transmit components.

It will be appreciated that reception of a GSM 850 signal can be achieved in the same way by turning on the receive isolation switch 32 and turning off the receive isolation switch 34 and the transmit isolation switch 28.

With this topology, virtually no loss occurs in the transmission mode by virtue of the transmit/receive switch. In particular, there is no series switching element in the transmit path beyond the power amplifier. The transmit isolation switch 28 is positioned upstream of the final stage 22 of the power amplifier. The current and power carried at this point is considerably less than that in the signal path downstream of the final stage 22. Therefore, even if the transmit isolation switch 28 introduces some loss when conducting, the overall effect on power consumption of the device is negligible. Transmit/receive switches located in the signal path downstream of the power amplifier have insertion losses of approximately 0.5 db. Elimination of these losses results in an increase in the effective efficiency of between 5% and 6%.

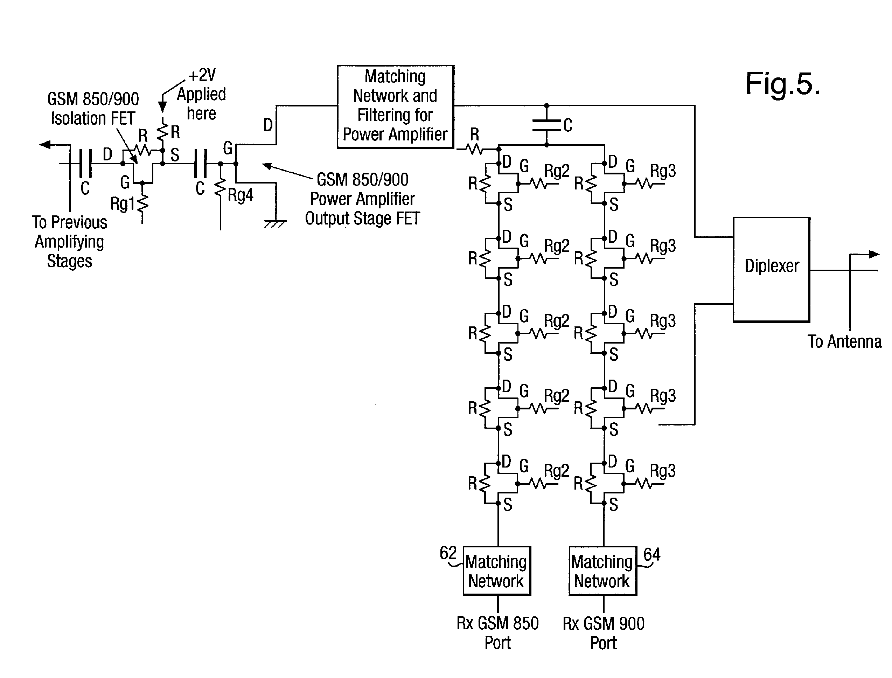

For reasons which will be described below, it is preferable that the receive isolation switches 22 and 24 connect to the signal path between the final stage 22 of the power amplifier and the matching network 24. However, the advantages discussed above with regard to reducing insertion loss during transmission can also be achieved with the receive isolation switches downstream of the matching network 24. This is illustrated in Figure 5.

As mentioned above, downstream of the matching network is high impedance, for instance approximately 50 ohms, for connection to the antenna. For this reason, when the receive isolation switches are connected downstream of the matching network, they must be capable of withstanding higher voltages, for instance of the order of 20 volts. Thus, as a practical embodiment, as illustrated in Figure 5, each receive isolation switch may be embodied as a plurality, for instance 5, of series connected FETs.

Thus, it will be appreciated that, by moving the receive isolation switches 32 and 34 to a position upstream of the matching network 24 where it is low impedance, it is possible to reduce the number of FETs required for the receive isolation switches and, therefore, reduce the overall physical size. As a practical matter, FETs on the high impedance side as illustrated in Figure 5 are required to carry less current and, hence, may only be of 4 mm. In contrast, the FETs on the low impedance side will be required to carry more current and may be 8 or 10 mm. However, there is still an overall saving in space and die area.

As mentioned above, the various components of Figure 3 may be provided as discrete components. In this way, the individual components may be provided by any devices giving the required functionality. For example, the final stage 22 may be provided as a bipolar transistor instead of an FET transistor.

In the preferred embodiment, each stage of the power amplifier and the transmit and receive isolation switches are provided as FETs. In this way, some or all of the components illustrated in Figure 3 may be constructed together as one or more modules, for instance using MMIC technology. By providing the transmit isolation switch 28 functionally adjacent the power amplifier (as opposed to on the other side of the matching network for the prior art), the transmit isolation switch 28 may be located physically adjacent the stages of the power amplifier. Similarly, with the receive isolation switches located immediately downstream of the final stage 22 as illustrated in Figure 3, the receive isolation switches may also be located physically adjacent the power amplifier. In this way, the isolation switches may be constructed together with the stages of the power amplifier, for instance as an MMIC, with significant space saving, in particular avoiding the need for extensive connecting tracks.

Normally the receive components of a mobile transceiver receive signals from the antenna at high impedance. However, according to the embodiment of Figure 3, the receive isolation switches 32 and 34 are connected to a low impedance portion of the signal path. Therefore, in order to allow the front end of Figure 3 to be used with otherwise conventional receive components, secondary matching networks 52 and 54 are provided respectively downstream of the receive isolation switches 32 and 34 for connection to receive components of the mobile transceiver. The matching networks 52 and 54 match the low impedance presented by the matching network 24 to the high impedance receive components.

For the embodiment of Figure 5, even when the transmit isolation switch and final stage of the power amplifier are turned off, the matching network still presents itself as low impedance to the signal path from the antenna. Hence, a mismatch will occur with receive components, even though they are connected to the downstream high impedance side of the matching network. To overcome this and to allow the front end to be used with otherwise conventional receive components, secondary matching networks 62 and 64 are provided downstream of the receive isolation switches so as to correct for the impedance presented by the matching network.

Returning, finally, to Figure 3, it will be seen that the transmit isolation switch 28 is connected in series between capacitors 70 and 72. These capacitors 70, 72 conduct the radio frequency signal, but provide a barrier to DC. In this way, any DC bias required by the transmit isolation switch 28 is not transmitted to the final stage 22 or previous stages of the power amplifier. Similarly, a capacitor 74 connects the receive isolation switches 32 and 34 to the signal path between the final stage 22 and the matching network 24. This prevents any DC bias provided to the receive isolation switches from effecting the final stage and any upstream stage or upstream transmit component.

## Claims

1. A mobile transceiver front end for connecting an antenna to transmit signal components, the front end including:
a power amplifier for connection to the transmit components and having at least a final stage for feeding the antenna; and
a transmit isolation switch for selectively isolating the antenna from the transmit components; wherein
the transmit isolation switch is connected in series with and upstream of the final stage of the power amplifier.

2. A mobile transceiver front end according to claim 1, further including:
a receive isolation switch for selectively connecting receive signal components to the antenna and isolating the receive signal components from said final stage.

3. A mobile transceiver front end according to claim 2, further including:
a signal path for connecting the output of the final stage to the antenna.

4. A mobile transceiver front end according to claim 3, wherein:
the signal path includes an antenna matching network such that the output impedance of said final stage can be matched to the input impedance of the antenna.

5. A mobile transceiver front end according to claim 4, wherein:
the antenna matching network includes filters for minimising a emission of unwanted harmonics.

6. A mobile transceiver front end according to claim 3, 4 or 5, wherein:
the receive isolation switch is connected to the signal path and is for selectively connecting receive components to the signal path.

7. A mobile transceiver front end according to claim 4 or 5, wherein the receive isolation switch is connected to the signal path between said final stage and the antenna matching network and is for selectively connecting the receive components to the signal path.

8. A mobile transceiver front end according to claim 7, wherein:
a secondary matching network is connected to the receive isolation switch for connecting the receive isolation switch to the receive components such that the impedance presented by the antenna matching network can be matched to the input impedance of the receive components.

9. A mobile transceiver front end according to claim 7 or 8, wherein:
the receive isolation switch comprises a series connected receive isolation FET.

10. A mobile transceiver front end according to claim 9, wherein:
the receive isolation FET is connected to the signal path via a capacitor for isolating the final stage from the DC bias of the receive isolation FET.

11. A mobile transceiver front end according to any one of claims 2 to 10, wherein:
the receive isolation switch is constructed together with the power amplifier and the transmit isolation switch as an MMIC.

12. A mobile transceiver front end according to any one of claims 1 to 10, wherein:
the power amplifier and the transmit isolation switch are constructed together as an MMIC.

13. A mobile transceiver front end according to any preceding claim, wherein:
the transmit isolation switch comprises a series connected transmit isolation FET.

14. A mobile transceiver front end according to claim 13, further including:
series connected capacitors either side of the transmit isolation FET to isolate at least the final stage from the DC bias of the transmit isolation FET.

15. A mobile transceiver front end according to any preceding claim constructed as an MMIC.

16. A module for use in a mobile transceiver, the module including a mobile transceiver front end according to any preceding claim.

17. A mobile transceiver including a mobile transceiver front end according to any one of claims 1 to 15.

18. A method of selectively isolating the transmit components of a mobile transceiver from a signal path connecting a power amplifier of the mobile transceiver to an antenna, the method including:
connecting a transmit isolation switch in series with and upstream of the final stage of the power amplifier.

19. A method according to claim 18, further including:
selectively connecting receive signal components to a signal path connecting said final stage to the antenna by means of a receive isolation switch connected to the signal path between said final stage and an antenna matching network in the signal path.
